Europäisches Patentamt

European Patent Office

Office européen des brevets

(11) Numéro de publication: **0 346 228**
**A1**

## DEMANDE DE BREVET EUROPEEN

(21) Numéro de dépôt: **89401580.9**

(22) Date de dépôt: **07.06.89**

(51) Int. Cl.⁴: **H 05 K 3/34**

(30) Priorité: **08.06.88 FR 8807604**

(43) Date de publication de la demande:
**13.12.89 Bulletin 89/50**

(84) Etats contractants désignés:
**DE ES FR GB IT NL SE**

(71) Demandeur: **BULL S.A.**
**121, Avenue de Malakoff**
**F-75116 Paris (FR)**

(72) Inventeur: **Fillaudeau, Gilles**
**25, avenue de la Grande Armée**
**F-75016 Paris (FR)**

(74) Mandataire: **Denis, Hervé et al**
**BULL S.A. Industrial Property Department PC 4X018 25**
**avenue de la Grande-Armée**
**F-75016 Paris (FR)**

(54) **Plaque de masquage de carte de circuits imprimés équipée et son procédé de fabrication.**

(57) La plaque de masquage (10) de carte de circuits imprimés (11) se compose d'au moins deux feuilles (13, 14) superposées, fixées l'une à l'autre et percées de façon que la feuille inférieure (14) soit conformée au masquage désiré de la carte et lui serve de support et que la feuille supérieure (13) serve au positionnement de la carte.

FIG. 2

EP 0 346 228 A1

**Description**

## Plaque de masquage de carte de circuits imprimés équipée et son procédé de fabrication.

L'invention se rapporte à une plaque de masquage de carte de circuits imprimés équipée, pour le soudage à la vague des composants enfichés dans la carte, et au procédé de fabrication d'une telle plaque.

Une carte de circuits imprimés équipée de composants enfichés dans des trous traversant la carte est montée sur un support pour le soudage à la vague de ces composants. Le soudage à la vague est le soudage collectif de composants à une carte par une vague d'étain en fusion se propageant sous la carte. La carte est faite en un matériau non mouillable par l'étain, une résine époxy habituellement. Les trous métallisés et les plages de connexion y sont préalablement étamés pour la formation de soudures efficaces et fiables au passage de la vague d'étain. Des éléments de masquage portés par le support de la carte évitent le contact de la vague d'étain avec certaines zones de la carte. Notamment, ces zones portent des composants sensibles à la chaleur ou des éléments annexes (picots, connecteurs, ...). Le support de la carte forme avec ses éléments de masquage une plaque de masquage.

Une plaque de masquage couramment utilisée jusqu'à présent est faite à partir d'une plaque pleine, d'abord fraisée pour la mise en place de la carte et la conformation des éléments de masquage, puis percée aux endroits où la vague d'étain doit ou peut être en contact avec la carte. La cavité formée par fraisage et détourage présente un premier niveau pour loger la carte et la positionner dans la plaque. Souvent, des niveaux inférieurs sont ménagés par fraisage et détourage pour loger les composants à protéger. Le fraisage et le détourage doivent donc généralement se conformer à un dessin complexe en volume, qui dépend du type de cartes de circuits imprimés. En pratique, il existe une très grande variété de cartes de circuits imprimés, différenciées selon notamment leur taille, l'agencement et la nature des composants, et certains éléments annexes (picots, ...). La fabrication actuelle d'une plaque de masquage requiert par conséquent des opérations complexes de fraisage et de détourage spécifiques à un seul type de cartes et s'avère donc coûteuse.

A l'origine, la plaque était métallique, dûment fraisée et détourée, puis parée d'une résine époxy au moins aux endroits destinés à venir en contact avec la vague d'étain. L'époxy évite l'adhérence de l'étain à la plaque. L'usinage de la plaque et son revêtement étaient donc longs et coûteux. Comme autre inconvénient, le métal de la plaque avait, sous l'action de la chaleur de la vague d'étain, un coefficient de dilatation différent de celui de la carte de circuits imprimés. Les plaques actuelles sont aussi en époxy. L'époxy offre de nombreux avantages : il n'est pas mouillable par l'étain en fusion, il s'usine sans difficulté, il subit l'action de la chaleur sans créer de variations différentielles entre la plaque de masquage et la carte, et il est moins coûteux que le métal. Mais actuellement une plaque de masquage en époxy demeure encore très onéreuse, à cause notamment des opérations de fraisage et détourage en volume.

L'invention présente une plaque de masquage tout aussi performante, mais ne requérant plus les opérations de fraisage et détourage en volume, délicates et coûteuses. En évitant ces opérations, la fabrication d'une plaque de masquage conforme à l'invention peut être dix fois moindre que celle d'une même plaque de masquage fabriquée de manière classique.

Selon l'invention, une plaque de masquage de carte de circuits imprimés est caractérisée en ce qu'elle se compose d'au moins deux feuilles superposées, fixées l'une à l'autre et percées de façon que la feuille inférieure soit conformée au masquage désiré de la carte et lui serve de support et que la feuille supérieure serve au positionnement de la carte.

L'invention a aussi pour objet un procédé de fabrication d'une telle plaque, caractérisé en ce qu'il consiste à percer une première feuille conformément au motif de masquage et à percer une seconde feuille pour être sensiblement conformée à la taille de la carte, puis à superposer et fixer les deux feuilles l'une à l'autre.

Les caractéristiques et avantages de l'invention ressortiront de la description qui suit, donnée titre d'exemple et faite en référence aux dessins annexés.

Dans les dessins :

-la figure 1 est une vue de dessus d'une plaque de masquage conforme à l'invention ;

-la figure 2 est une vue en coupe suivant la ligne II-II de la plaque de masquage représentée sur la figure 1 et destinée au soudage à la vague d'une carte de circuits imprimés vue en coupe et positionnée à l'écart de la plaque de masquage pour des raisons de clarté ;

-la figure 3 est une vue de dessus d'une variante de réalisation d'une plaque de masquage conforme à l'invention montée dans un cadre normalisé, adapté à une machine de soudage à la vague ; et

-la figure 4 est une vue en coupe suivant la ligne IV-IV de la plaque de masquage et du cadre représentés sur la figure 3, la plaque de masquage étant destinée au soudage à la vague d'une carte de circuits imprimés vue en coupe et positionnée à l'écart de la plaque pour des raisons de clarté comme dans la figure 2.

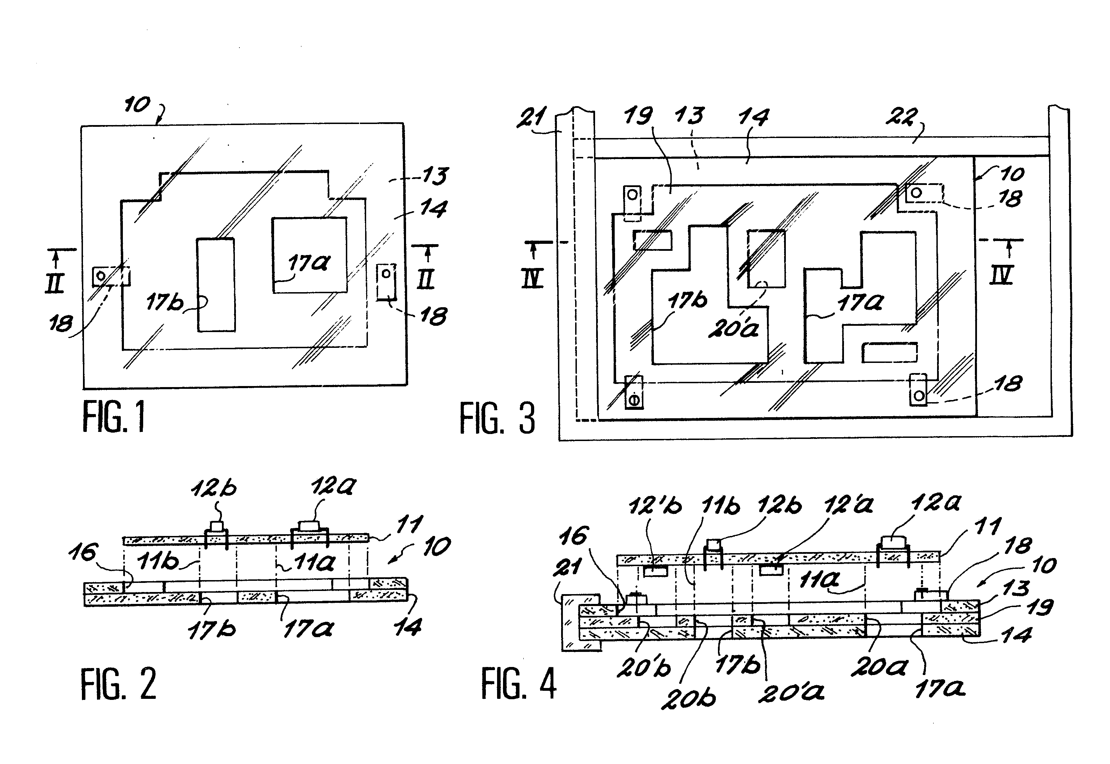

Les figures 1 et 2 illustrent le mode de réalisation préféré d'une plaque de masquage 10 conforme à l'invention pour le soudage à la vague d'une carte de circuits imprimés 11. La carte 11 est ordinairement une carte multicouche en verre époxy de circuits imprimés. Elle a une face équipée de composants 12 pourvus de pattes introduites dans des trous traversant la carte de façon qu'une vague d'étain en fusion passant sous la carte fixe collectivement les pattes aux trous correspondants de la carte. L'exemple illustré dans les figures 1 et 2 se rapporte au soudage de deux composants 12a, 12b par une vague ne pouvant être en contact que dans deux régions correspondantes sous-jacentes 11a, 11b de la carte 11. La plaque de masquage 10 sert à la fois de support adapté à la carte 11 et à la machine de soudage à la vague et d'élément de masquage pour seulement découvrir les régions 11a, 11b de la carte 11.

Selon l'invention, la plaque de masquage 10 représentée sur les figures 1 et 2 est faite de deux feuilles superposées, fixées l'une à l'autre et préalablement percées. Les deux feuilles 13, 14 sont de préférence faites du même matériau que la carte 11, en résine époxy habituellement, et sont superposées puis collées l'une à l'autre par une couche adhésive 15 à base d'époxy. Le dispositif 10 offre ainsi les mêmes caractéristiques et avantages que la carte 11. Préalablement à leur assemblage, la feuille supérieure 13 est percée, par découpage ou par détourage par exemple, pour former une ouverture 16 aux dimensions de la carte 11, tandis que la feuille inférieure 14 est percée pour présenter les ouvertures 17 (17a, 17b) correspondant aux régions 11a, 11b de la carte 11. De la sorte, la feuille inférieure 14 sert de support à la carte 11 et de masque pour cette carte et la feuille supérieure 13 a simplement pour rôle de positionner la carte 11 par rapport aux éléments de masquage de façon à ne découvrir que les régions 11a, 11b acceptant le contact avec la vague d'étain. Ce positionnement horizontal est associé, dans l'exemple illustré, à un positionnement vertical simplement assuré par deux brides 18 manipulées pour tourner autour d'un axe fixé à au moins l'une des feuilles 13,14.

La fabrication d'une plaque de masquage 10 conforme à l'invention est simple, rapide, peu coûteuse et bien adaptée à une production à échelle industrielle. Etant donné que les feuilles 13, 14 sont minces et faites de résine, le perçage de feuilles 13 (ou 14) conformément à un dessin identique peut avantageusement se faire en une seule fois sur un empilement de ces feuilles. En outre, le découpage peut aisément être modifié en fonction du motif des masques, et l'assemblage par collage est simple et peu coûteux.

La plaque de masquage 10 illustrée dans les figures 1 et 2 peut être modifiée à l'évidence de ce qui précède. Par exemple, l'ouverture 16 a pour rôle de positionner la carte 11 dans la plaque de masquage 10 et peut être conformée différemment de la carte 11 tout en remplissant la fonction de positionnement, et ne présenter par exemple que des butées de positionnement plus faciles à détourer. D'autre part, une simple plaque 10 composée des feuilles 13, 14 peut être conformée pour recevoir une pluralité de plaques 11. Ces plaques peuvent être juxtaposées de façon à n'avoir par exemple qu'une seule ouverture commune 16 à percer dans la feuille 13. De même, les brides 18 peuvent ou non être tournantes et être communes à plusieurs cartes.

Les figures 3 et 4 illustrent une variante de réalisation d'une plaque de masquage 10 pour le soudage à la vague d'une carte de circuits imprimés 11 équipée sur ses deux faces. Comme dans le cas de la figure 2, la carte 11 porte sur sa face supérieure des composants 12 (12a, 12b, ...) enfichés pour être soudés à la vague sur l'autre face. Cependant, la carte 11 porte aussi sur sa face inférieure des composants ou éléments 12' (12'a, 12'b, ...) qu'il ne faut pas mettre en contact avec la vague d'étain. La plaque de masquage 10 représentée sur la figure 4, adaptée au soudage à la vague des composants 12 de la carte 11, est faite de trois feuilles prédécoupées, superposées et fixées l'une à l'autre. La feuille supérieure 13, comme dans le cas des figures 1 et 2, a été percée pour obtenir une ouverture 16 servant au positionnement de la carte 11 par rapport aux autres feuilles. La feuille inférieure 14, comme dans le cas des figures 1 et 2, a été percée pour former deux ouvertures 17a, 17b définissant respectivement les régions 11a, 11b de la carte 11 pouvant être en contact avec la vague d'étain. La feuille inférieure 14 sert donc de masquage. Une feuille intermédiaire 19 est interposée entre les feuilles 13 et 14 et a été percée pour présenter deux types d'ouvertures, à savoir des ouvertures 20 (20a, 20b) correspondant aux ouvertures 17 (17a, 17b) ménagées dans la feuille inférieure 14 pour le soudage à la vague des composants 12 et des ouvertures 20' (20'a, 20'b, ...) pour loger les composants ou éléments 12' (12'a, 12'b, ...) de la face inférieure de la carte 11. La feuille 19 sert donc de support à la carte 11 aux endroits où elle peut être en contact avec la carte, c'est-à-dire en dehors des ouvertures 20' correspondant aux composants ou éléments 12'. La feuille 19 s'associe également avec la feuille inférieure 14 pour servir de masque et ne laisser que les régions 11a et 11b pouvant entrer en contact avec la vague d'étain. Comme dans le cas des figures 1 et 2, les trois feuilles de la plaque de masquage 10 sont avantageusement faites du même matériau que celui de la carte 11 et sont collées par des couches adhésives 15 de même nature. Des brides 18 sont aussi prévues pour le maintien en position verticale de la carte 11 dans la plaque de masquage 10.

Evidemment, la plaque de masquage 10 représentée sur les figures 3 et 4 peut recevoir les mêmes variantes que celles décrites en référence avec la plaque représentée sur les figures 1 et 2. Il est à noter qu'une plaque de masquage peut inclure en général au moins une ouverture pour souder l'ensemble des composants 12 et que les feuilles 13, 14 et 19 peuvent avoir des épaisseurs différentes. Notamment dans la plaque de masquage 10 représentée sur les figures 3 et 4, la feuille 14 peut être plus mince que la feuille 19 ou 13 afin de réduire la profondeur des ouvertures (17a, 20a ; 17b, 20b) offertes à la vague d'étain. Les figures 3 et 4 illustrent une autre variante selon laquelle la plaque de masquage 10 est montée sur un cadre 21 rigide, métallique par exemple. Le cadre 21 peut servir à rigidifier les plaques de masquage 10, surtout lorsqu'elles sont de grandes tailles. Comme illustré, le cadre 21 peut aussi servir à l'adaptation de toute plaque de masquage à une machine de soudage à la vague ne fonctionnant qu'avec des cadres de taille normalisée. Le cadre 21 a cette taille normalisée et porte une réglette 22 réglable longitudinalement de façon à s'accommoder de toute taille de plaque de masquage 10.

**Revendications**

1. Plaque de masquage (10) de carte de circuits imprimés (11), caractérisée en ce qu elle se compose d'au moins deux feuilles (13, 14) superposées, fixées l'une à l'autre et percées de façon que la feuille inférieure (14) soit conformée au masquage désiré de la carte et lui serve de support et que la feuille supérieure (13) serve au positionnement de la carte.

2. Plaque selon la revendication 1, caractérisée en ce qu'elle comporte au moins une feuille intermédiaire (19) percée pour loger les composants ou éléments disposés sur la face masquée de la carte.

3. Plaque selon la revendication 1 ou 2, caractérisée en ce que les feuilles sont faites d'un matériau identique ou similaire à celui de la carte.

4. Plaque selon la revendication 3, caractérisé en ce que les feuilles sont collées par une couche adhésive (15) à base du même matériau que les feuilles.

5. Plaque selon la revendication 3 ou 4, caractérisée en ce que le matériau est une résine époxy.

6. Plaque selon l'une des revendications 1 à 5, caractérisée en ce qu'elle porte des brides (18) pour la fixation de la carte (11) dans la plaque.

7. Plaque selon l'une des revendications 1 à 6, caractérisée en ce qu'elle est portée par un cadre métallique (21).

8. Plaque selon la revendication 7, caractérisée en ce que le cadre métallique (21) a une taille normalisée et inclut une réglette (22) mobile pour y fixer la plaque indépendamment de sa taille.

9. Procédé de fabrication d'une plaque de masquage définie par l'une des revendications 1 à 8, caractérisé en ce qu'il consiste à percer une première feuille (14) conformément au motif de masquage et à percer une seconde feuille (13) pour être sensiblement conformée à la taille de la carte, puis à superposer et fixer les deux feuilles l'une à l'autre.

10. Procédé selon la revendication 9, caractérisé en ce qu'il consiste à percer au moins une troisième feuille (19) selon sensiblement le motif défini par les composants ou éléments disposés sur la face masquée de la carte et à insérer la troisième feuille entre les première et seconde feuilles.

FIG. 1

FIG. 2

FIG. 3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | IBM TECHNICAL DISCLOSURE BULLETIN, vol. 25, no. 7A, décembre 1982, page 3177, New York US; N.G. AAKALU et al.: "Protective shield/solder dam for substrates" <br> * En entier * <br> --- | 1,2,5,9 | H 05 K    3/34 |
| A | US-A-4 739 919  (J. VAN DEN BREKEL) <br> * Figure 7, colonne 1, lignes 37-50; colonne 2, lignes 30-48 * <br> --- | 1,2 | |
| A | IBM TECHNICAL DISCLOSURE BULLETIN, vol. 9, no. 3, août 1966, pages 234-235, New York US; C.W. SCHWENN: "Solder mask" <br> * En entier * <br> ----- | | |

DOMAINES TECHNIQUES RECHERCHES (Int. Cl.4)

H 05 K
B 23 K

Le présent rapport a été établi pour toutes les revendications

| Lieu de la recherche | Date d'achèvement de la recherche | Examinateur |
|---|---|---|
| LA HAYE | 11-09-1989 | MOMENE Y ARROYO M.E. |